# EUROPEAN PATENT SPECIFICATION

(11) **EP 4 466 576 B1**
(45) Date of publication and mention of the grant of the patent: **21.10.2026**
(21) Application number: 23703400.4
(22) Date of filing: 13.01.2023
(51) Int. Cl.: G02F 1/15

(54) **LIGHT DRIVEN ELECTROCHROMIC DISPLAY**
LICHTGESTEUERTE ELEKTROCHROME ANZEIGE
AFFICHAGE ÉLECTROCHROMIQUE COMMANDÉ PAR LA LUMIÈRE

(30) Priority: 17.01.2022 EP 22151896
(43) Date of publication of application: 27.11.2024
(73) Proprietor: Freshape SA, 1020 Renens (CH)
(72) Inventor: KUNG, Yen-Cheng, 1110 Morges (CH); LIU, Yuhang, 1030 Bussigny (CH)
(74) Representative: Schneiter, Sorin
(86) International application number: PCT/EP2023/050773
(87) International publication number: WO 2023/135270

(56) References cited:
- US-A1- 2003 076 573
- US-A1- 2019 384 133
- US-A1- 2020 004 098
- US-B1- 7 116 309

## Description

### Technical Field

The present invention generally relates to the field of displays, in particular to light driven displays, passive displays, reflective displays, electrochromic displays, and to displays belonging to two or more of the aforementioned categories.

### Background Art and Problems Solved by the Invention

In recent years there have been efforts to provide passive displays as an alternative to the currently widespread active displays, such as liquid crystal displays (LCD) or organic light emitting diode (OLED) displays. Such prior art displays have the disadvantages of emitting light and thereby being tiring to the human eye, having a relatively narrow viewing angle, high energy consumption, low contrast, and not being adapted to the varying environmental light, for example in outdoor conditions. In passive screens, on the other hand, the image is not produced by light emission, such as light-emitting pixels, but by the reflection of environmental light on or in the screen. Watching a passive display corresponds more to watching a printed medium than using a luminosity-based screen. Passive screens do not exhibit the disadvantages mentioned above and may thus be considered particularly advantageous for outdoor screens (higher contrast under direct solar irradiation) and for screen-based reading (high contrast, less tiring to the human eye). Passive displays are sometimes also referred to as electronic paper, e-paper or ink-displays.

Currently, few passive screens are commercially available, and, to the knowledge of the applicant, no competitive full-color passive display is currently on the market. Full-color e-papers have been conceived, however, their performance is generally poor, in terms of color purity and/or contrast. A disadvantage applicable to all screens based on an active matrix is that the display surface is generally limited to the size of the active matrix. Challenges with existing technologies of such displays concern manufacturing costs, non-scalable display sizes, the generally low switching times and achieving full-color displays.

US 8,547,313 B2 discloses a photo-addressed display and a driving apparatus for the display comprising a light applying unit. The architecture of the display comprises a light modulation layer comprising liquid crystals, and an organic photosensitive layer capable of absorbing addressing light, generating a charge carrier and enabling a current flow between two electrodes for acting on the liquid crystals. It is not disclosed how cross-talk over the electrode-covered surface is prevented in this device, once current flow is triggered by the addressing light. In addition, this device is a single-color device. Finally, the device requires back illumination to drive the display, as otherwise the addressing light is expected to interfere with the image display.

Haruo Harada et al, "Full-color photo-addressable electric paper using cholesteric liquid crystals and organic photoconductors", Journal of the SID 16/12, 2008, disclose a similar principle based on liquid crystals, having however a complex, multilayer architecture in order to account for full-color properties. In this device, two electrode pair devices are stacked one above the other, wherein the upper device comprises two stacked liquid crystal layers for blue and green colors, and the lower device for the red color, so as to allow full color display by RGB color mixing. This device is complex to manufacture and consumes more power due to the requirement of two stacked electrode pairs. Similar with US 8,547,313 B2, back illumination is required.

US 2020/0004098 A1 discloses a reflective color display that can be addressed from the front with light from a projector, LED or laser. The device comprises a color filter array (CFA) a bistable display media, and a photoconductive material, sandwiched between a pair of electrodes. The bistable media means that a displayed image remains displayed for a certain time even if the display is not up-dated rapidly. The bistable media is generally provided in the form of rotating bichromal spheres or cylinders, in particular electrophoretic particles. The document is silent with respect to the avoidance of cross talk along the continuous electrode used in this device. The device also requires an electrical potential applied in the form of a time-dependent wave form, which is more likely only achievable with complicated circuit design. The color filter array (CFA) used on the display side may affect the clarity and/or brightness of the image displayed by the screen.

US 2003/0076573 differs from US 2020/0004098 in that it relates to back driven displays. In the full color display, particles of photoconductive materials having different sensitivities are used, wherein different migration behavior or different electrophoretic properties of different materials result in sub-pixels displaying the appropriate color.

US 7,116,309 discloses a full-color photo-writing display comprising stacked layers each having a pair of electrodes, a photoconductor layer and an electrochromic (EC) layer. For the the full-color property, different photoconductors having different spectral sensitivities are used, such that some photoconductors can be addressed by different driving light. In another operation mode, a bias voltage is selectively applied to those electrodes that act on the EC layers containing the EC material with the desired color.

It is an objective of the invention to provide a passive display, which avoids the limitations found in the prior art. It is thus an objective of the invention to provide displays that can be realized easily and cost efficiently in all desired sizes, including large, outdoor displays. It is an objective to provide a technology that can also be used for providing a full-color display. Furthermore, it is an objective to provide a display having fast switching times, enabling thus rapid changes of the displayed images, including rapid erasure and/or rapid generation of a new image on the display. It is an objective of the invention to provide a light-addressable display.

Further objectives and problems addressed by the present invention will become apparent from the description of the aspects and embodiments of the invention herein below.

### Summary of the Invention

Surprisingly, the present inventors provide a photo-addressable, preferably reflective display comprising first, second and third different electrochromic materials, wherein the color state of the display can preferably be controlled with the aid of a pair of electrodes.

In an aspect, as defined in appended claim 1, the invention provides a photo-addressed and/or photo-addressable display comprising first and second electrode layers and a conductor layer, whose conductivity can be adjusted by applying electromagnetic irradiation. This layer, which will be referred to as photoconductor layer, is provided between the electrode layers. The display of the invention further comprises an electrochromic material layer provided between said photoconductor layer and said first electrode layer), wherein said electrochromic material layer comprises first, second and third different electrochromic materials, provided in first, second and third spatially separate regions in said electrochromic material layer.

According to the claimed invention, the photoconductor layer comprises a material that is sensitive to infrared light (IR) and optionally the display further comprises one or more infrared (IR) filtering material, which is provided in a separate layer or provided in said electrochromic material layer.

In an embodiment, the display of the invention further comprises a visible light reflecting material and/or layer, which preferably reflects all and/or nearly all light of the visible spectrum and provides a background for information and/or images displayed on said display. In an embodiment, the display of the invention further comprises a light source, such as a projector, LED, laser, for example.

In a preferred embodiment, the display of the invention comprises a white light scattering and/or reflecting material, provided in said electrochromic material layer, in a layer comprising said infrared (IR) filtering material, or in a separate layer, wherein said white light scattering and/or reflecting material preferably provides a background for information and/or images displayed on said display.

Further aspects and preferred embodiments of the invention are defined herein below and in the appended claims. Further features and advantages of the invention will become apparent to the skilled person from the description of the preferred embodiments given below.

### Brief Description of the Drawings

**Figures 1A** and **1B** schematically shows the architecture of displays according to a first and second embodiment of the invention, provided for mono-color and full-color display, respectively. From these embodiments only the embodiment of Figure 1B referring to a full-color display is according to the claimed invention.
**Figures 2A** and **2B** schematically illustrate the operation of the photo-driven operation of the display in accordance with an embodiment of the invention.
**Figures 3** schematically shows in more detail the architecture of a full-color, front-light driven display according to an embodiment of the invention.
**Figure 4** schematically shows in more detail a full-color, front-light driven display according to another embodiment of the invention.
**Figure 5** schematically shows in more detail a full color display according to yet another embodiment of the invention.
**Figures 6A** and **6B** schematically show full-color, back-side, photo-driven displays according to further embodiments of the invention.
**Figures 7A** and **7B** schematically show full-color transparent displays according to still further embodiments of the invention.
**Figures 8A** and **8B** show a schematic drawing and a photograph, respectively, of a device in accordance with an embodiment of the invention, which is not according to the claims.

Hereinafter, preferred embodiments of the device of the invention are described, in order to illustrate the invention, without any intention to limit the scope of the present invention, which is defined by the appended claims.

### Detailed Description of the Preferred Embodiments

The present invention relates to a photo-addressed or photo-addressable display, as defined in appended claim 1. In the display of the invention, an image is preferably generated by irradiating the display with IR light. In a preferred embodiment, said IR light includes near IR light. In another embodiment, said IR excludes near IR light. In a preferred embodiment, the light for addressing the display has a wavelength in the range of 700-1000 nm.

In an embodiment, the display of the invention comprises a light irradiation unit configured for emitting IR light, and preferably IR light of three or more different wavelengths or wavelengths ranges.

Preferably, the display is irradiated by way of an irradiation source, such as a suitable projector, laser, laser projector, LCD projector, and LED, for example. Preferably, the irradiation source is suitable to project an image and/or to produce a patterned image, preferably with IR light.

The term "image" is used in the present specification to refer to graphical and also written visually displayed content, without any limitation. It includes images, text, numbers, symbols, information, in as far as it can be rendered visible to the human eye on a display.

The term "display" used in this specification is intended to include all sorts of objects comprising a preferably continuous surface suitable to render visible an image as defined above. Examples of displays include e-paper, flatscreens, boards, paper-board-type surfaces, flexible and solid objects, windows, walls, projector surfaces, and so forth. The display may be flexible or rigid. Furthermore, the display may be flat, curved or otherwise structured. Preferably, the display is suitable to generate said image on the basis of electronically stored information, such as information in the form of a computer-readable file.

The display of the present invention is preferably "reflective" and/or "passive". These terms are intended to mean that the image shown on the display is visible through the reflection of environmental light, as is the case with printed media such as books, magazines, and the like, and is preferably not produced by visible light-emitting units, such as LED displays, OELD displays, back-lit LCDs, and plasma displays, for example. Accordingly, the display preferably provides a comparatively large viewing angle, a high contrast and good visibility at different out-door conditions.

In preferred embodiments, the display of the invention is front driven, which means that the irradiation used to drive the display (to generate an image) is emitted towards and enters the display at the viewing side of the display. In another embodiment, the display of the invention is back-driven, meaning preferably that the irradiation used to drive the display is emitted towards the side that is opposite the viewing side. In a back-driven display, the light driving the generation of the image enters the device from the back side.

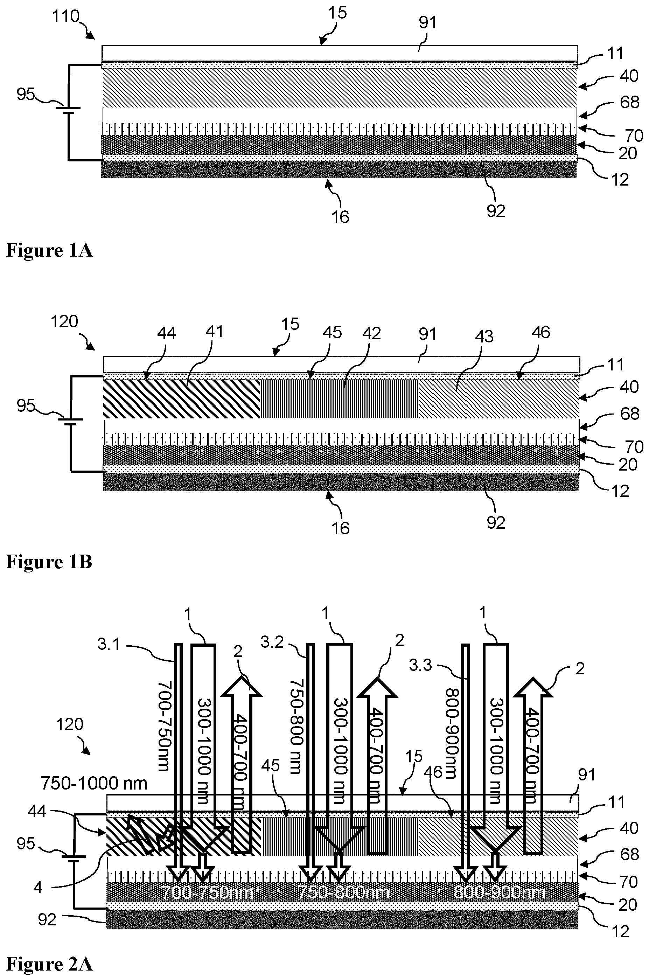

The display of the invention is described with respect to Figures 1A through 7B, in which like structures and/or functions have like numbering.

**Figure 1A** shows a display 110 , which is not according to the claimed invention, comprising first and second, front and rear electrodes 11, 12, respectively. At least the front electrode 11, which is provided towards the viewing side of the display, is preferably transparent to at least visible light and preferably also to IR light. The front electrode 11 is preferably associated with a front substrate 91, which is preferably also transparent to at least visible and IR light.

In a preferred embodiment, the display comprises a transparent front substrate 91, wherein said first electrode 11 is supported on and/or deposited on said transparent front substrate 11, and wherein said transparent front substrate 91 is preferably permissive to IR light.

The display or viewing side of the display 110 is indicated with reference numeral 15, which is thus provided on the side of the first electrode 11 and/or associated with the transparent substrate 91.

The back electrode 12 is preferably associated with a back substrate 92. The back electrode and back substrate need not be transparent. Preferably, the back substrate 92 is non-transparent to visible light and preferably absorbs and/or reflects all visible light. In the embodiments shown, the back substrate 92 forms the back side 16 of the device, which is in most embodiments opposed to the display side 15.

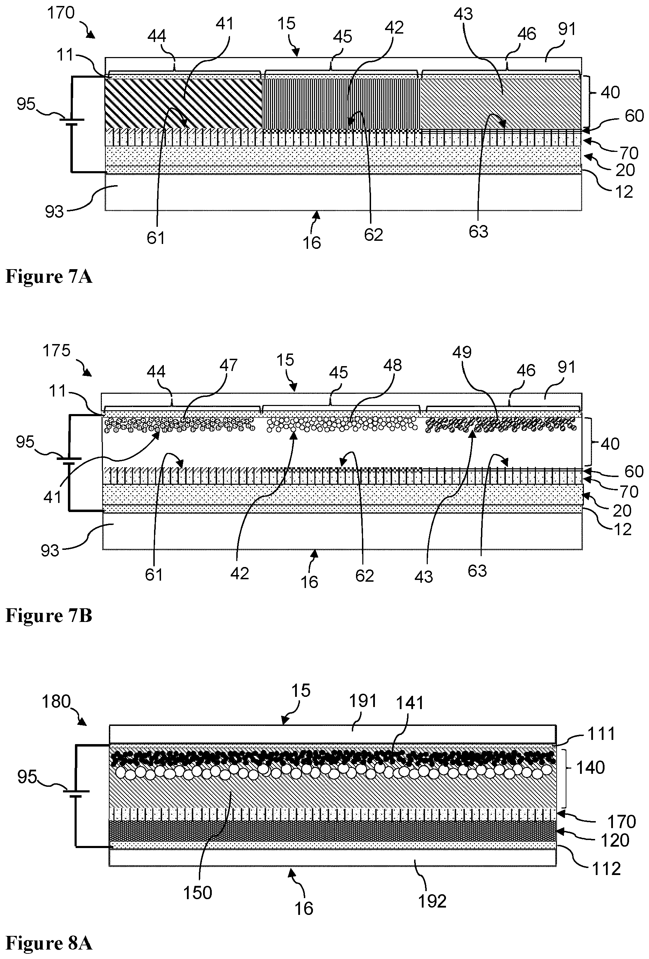

In an embodiment, illustrated in Figs 7A and 7B, the display comprises a transparent back substrate 93, wherein said second electrode 12 is supported by and/or deposited on said transparent back substrate 93.

Preferably, one or both first and second electrodes 11, 12 are continuous electrodes, covering the front and/or back substrate in a preferably continuous manner. Preferably, one or both electrodes extend continuously over a plurality of pixels and/or sub-pixels, more preferably over all the pixels and/or subpixels of the device. Preferably, the one or both electrodes extend continuously across the entire or the major part of the display surface. Preferably, one or both electrodes are addressable, respectively, as one single electrode (or, together, as one pair of opposed electrodes) and are not composed of a plurality of separated electrodes. Preferably, the electrodes are not part of an active matrix.

Preferably, the display of the invention lacks a stack of three or more electrodes and/or a stack of a plurality of electrochromic display members each display member including an electrochromic layer and a photoconductor layer.

In an embodiment, the display comprises a bias voltage applying unit 95 for providing a bias voltage between said first and second electrodes 11, 12.

The display 110 comprises a photoconductor layer 20 and an electrochromic material layer 40.

For the purpose of the present specification, the term "layer" includes the plural form "layers" and thus encompasses that the corresponding layer comprises and/or essentially consists of several layers. Furthermore, a layer may comprise different components shown as separate layers in the figures. Accordingly, what is shown as separated layers in the figures may but need not necessarily be incorporated in a single discernible or distinguishable layer. For example, in some cases, the electrochromic material layer 40 comprising one or more electrochromic material may further comprise one or more selected from an IR filtering material, a white light scattering and/or reflecting material and an anisotropic layer, which layers and materials may in some embodiments also be provided in the form of layers that are separate and or distinguishable from the layer 40. Instead of a single IR filtering material, a plurality of IR filtering materials may be present.

In a preferred embodiment, said photoconductor layer 20 comprises a plurality of layers, for example 2-10 or 2-5 layers, including one or more charge generation layers comprising said material that is sensitive to infrared light (IR), and one or more charge transport layer, comprising materials selected from electron and hole transport materials.

For the purpose of the present specification, the "photoconductor" layer is a layer whose conductivity can be adjusted by exposing the layer to electromagnetic irradiation having a predefined wavelength or wavelength range, preferably IR light.

In a preferred embodiment, the photoconductor layer 20 comprises and/or functions as a photodiode.

Preferably, the photoconductor layer 20 and has the function of enabling and/or triggering the current flow and/or the voltage between the electrodes upon irradiation with suitable light, in particular IR light. The photoconductor layer may be provided as described in US 8,547,313, comprising a charge transport layer sandwiched between two charge generation layers. The charge generation layer preferably comprises a photosensitive material, that is capable of absorbing addressing radiation, generating an exciton, and efficiently separating a free carrier in the charge generation layer or at the interface between the charge generation layer and the charge transport layer. The charge transport layer is a layer into which the radiation-generated charge carrier is poured, and has the function of drifting in an electric field applied with a bias signal. A photoconductive layer that may be used in accordance with the present invention is also referred to in US 2020/0004098 A1.

In a preferred embodiment, the photoconductor layer 20 comprises a perovskite material, preferably an organic-inorganic perovskite photodiode layer, in particular an organic-inorganic perovskite photodiode. In an embodiment, the photodiode has an external quantum efficiency in the IR region of more than 100%, preferably more than 1000%.

In a preferred embodiment, the photoconductor layer 20 comprises an organic ammonium metal halide perovskite, wherein the metal may be selected from Cu²⁺, Ni²⁺, Co²⁺, Fe²⁺, Mn²⁺, Cr²⁺, Pd²⁺, Zn²⁺, Cd²⁺, Ge²⁺, Sn²⁺, Pb²⁺, Eu²⁺, Yb²⁺, Bi³⁺ and Sb³⁺; preferably lead and/or from tin cation, for example. In an embodiment, the photoconductor layer 20 comprises an organic-inorganic perovskite material, for example as disclosed in WO2014180780A1. The perovskite material may be mixed anion, for example mixed halide and/or mixed cation perovskite.

Such perovskite materials have been reported to be sensitive to IR light and to generate charge carriers upon illumination with IR light. Typically, the organic-inorganic perovskite material will be sandwiched between an electron and a hole conducting layer.

In a preferred embodiment, the photoconductor layer 20 comprises an organic-inorganic perovskite photodiode layer, in particular an organic-inorganic perovskite photodiode exhibiting an external quantum efficiency of >100%, more preferably >500%, and most preferably >1000% in the IR region.

Suitable perovskite photodiodes are disclosed, for example, in Hsin-Wei Chen et al, "A Switchable High-Sensitivity Photodetecting and Photovoltaic Device with Perovskite Absorber", J. Phys. Chem. Lett. 2015, 6, 1773-1779, and also in Thomas Moehl etv al., "Strong Photocurrent Amplification in Perovskite Solar Cells with a Porous TiO2 Blocking Layer under Reverse Bias", J. Phys. Chem. Lett. 2014, 5, 3931-3936. In some embodiment, the photoconductor layer 20 comprises a mesoporous layer, for example a porous TiO₂ layer.

In some embodiments, the NIR sensitive photoconductor layer 20 comprises a photodiode based on silicon or another photoactive material. Photoactive materials other than silicon and the perovskites described above may be selected from GaAs, Ge, InP, PbS, PbSe, Ag₂S, Ag₂Se, Cu₂S, CuO, titanyl phthalocyanine, for example. The NIR sensitive photoconductor layer may comprise a combination of two or more different photoactive materials.

In an embodiment, the photoconductor layer 20 comprises a photosensitive p-n-junction.

The display of the present invention comprises first, second and third different electrochromic materials. The electrochromic material is preferably provided in the electrochromic material layer 40.

Electrochromic materials are materials that change their color depending on the oxidation status, and in particular in dependence of an applied voltage suitable to induce the electrochromic material to undergo a redox reaction. The display of the invention comprises three or four electrochromic material layers, which comprise different electrochromic materials. Preferably, the electrochromic materials are preferably independently capable of having at least a substantially transparent state and a coloured state, depending on the applied voltage. In the coloured state, the electrochromic material preferably exhibits a dark color (dark blue, dark green, dark red, or dark black) or a color selected from yellow, cyan, magenta and black, for example. The particular display as shown in Fig. 1A ,which is not according to the claims, is a mono-color display, comprising an electrochromic material having a dark color in one state and being substantially transparent in another state.

The electrochromic material layer 40 may be provided in the form of an all-in-one (AIO) layer, in which the electrochromic materials are preferably capable of being at least partially mobile, for example capable of moving towards and/or away from an electrode. In this embodiment, the electrochromic material is preferably capable to diffuse at least partially within the electrochromic layer 40 and/or is preferably non-bound. The diffusion preferably occurs within a matrix or electrolyte comprising a solvent. In accordance with this embodiment, the electrochromic materials are preferably small or medium sized molecules and/or non-polymeric. Preferably, in an AIO configuration, the electrochromic material is not deposited.

Preferably, as used herein, the term "small or medium sized molecule" refers to a substance or compound that has a molecular weight of less than 5'000, preferably less than 4'000, more preferably less than 3'000, and most preferably less than 2'500 Da.. In a preferred embodiment, the small or medium sized molecule has a molecular mass of ≤2'000 Da. Typically, small or medium sized molecules are not polymers, proteins, polypeptides, or nucleic acids, though they may comprise amino acids, di- and oligomers. "Small molecules" are generally molecules having a molecular mass of ≤ 800 Da.

In another embodiment, the electrochromic material is deposited and forms preferably a layer within the overall electrochromic material layer 40, forming an electrochromic layer. In this case, the electrochromic material is preferably immobile, not capable of moving by diffusion, and may be polymeric. In this case, the electrochromic material is preferably deposited on a substrate, such as on an electrode or on a mesoporous material that is preferably itself deposited and immobile with respect to the electrode.

The electrochromic material layer 40 preferably comprises one or more solvent, one or more salt, optional polymers and possibly other layers, such as an ion storage layer, for example, and additives and/or redox species as required to provide a functional electrochromic unit. The electrochromic material layer 40 preferably comprises an electrolyte, for example a gelled electrolyte.

The display 110 preferably comprises a light reflecting material and/or filtering layer 68. One function or the major function of layer 68 is to reflect all or most visible light and preferably to let pass at least some IR light. By reflecting visible light, the reflective layer 68 preferably provides a clear and/or bright, preferably light-colored, for example a clear grey or preferably a white background layer. Preferably, the light reflecting material and/or layer 68 provides a background against which information and/or images are contrasted and thereby rendered visible on said display to a human viewer. Preferably, the layer 68 comprises a white light scattering and/or reflecting material.

Preferably, said light reflective material and/or layer 68 provides the background for the image displayed by the one or more electrochromic materials. Accordingly, the reflective layer 68 preferably scatters white light and/or light of nearly all of the visible spectrum.

In a preferred embodiment, the reflective layer 68 does not reflect and/or absorb all IR light.

In a preferred embodiment, said visible light reflecting material and/or reflective layer 68 is transmissive to at least some wavelengths of IR light.

In an embodiment, the reflective layer 68 selectively reflects, absorbs or filters some IR light and is transmissive to specific, let-pass wavelengths of IR light.

In an embodiment, the reflective layer 68 is provided in the form of particles, such as micro- or nanoparticles, for example as described elsewhere in this specification with respect to other embodiments.

In a preferred embodiment, said white light scattering and/or reflecting material 80 or layer 68 is provided between said photoconductor layer 20 and said electrochromic material layer 40, or in said electrochromic material layer.

In an embodiment, the display comprises one or more IR filtering material, which is provided in a separate layer or film between said photoconductor layer 20 and said first electrode 11, preferably between said photoconductor layer 20 and said electrochromic material layer 40. If a conductive anisotropic layer is present (see further below), the one or more IR filtering material may be provided between said anisotropic layer and said first electrode 11, preferably between said anisotropic layer and said electrochromic layer 40.

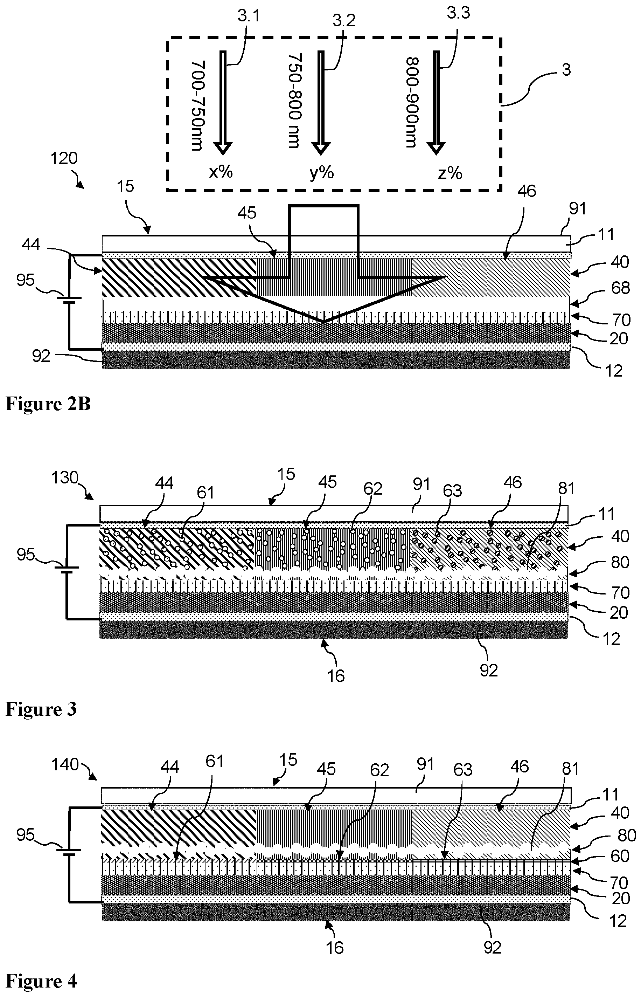

In a single-color device, the display preferably comprises one or no IR filtering material. A plurality of different IR filtering materials 61, 62, 63, as described with respect to Figs. 3 and 4, for example, is not mandatary and is preferably absent.

In a preferred embodiment, the display of the invention comprises an anisotropic conductive layer 70. The function of this layer is to suppress cross-talk and to limit and/or channel current flow in particular regions of the display, which are irradiated. As has been mentioned above, the first and/or second electrodes are preferably provided continuously over the entire area covered by the display area. The conductive anisotropic layer 70 makes sure that current flow occurs only locally or is locally limited to those areas of the display where addressing irradiation impinges on the photoconductor layer 20. The conductive anisotropic layer 70 is preferably provided between said electrochromic material layer 40 and said photoconductor layer 20, more preferably between said reflecting and/filtering layer 68 and said photoconductor layer 20.

Anisotropic conductive layers and materials to produce them are commercially available and may be produced according the procedure described in US 6,592,783 B2, for example.

The anisotropic conductive layer 70 is preferably suitable to provide a better image quality and/or resolution. However, an anisotropic conductive layer is not mandatory, as the invention may also be put in practice without such a layer.

As can be seen in Fig. 1A, the photoconductor layer 20 is provided between said electrode layers 11, 12. The electrochromic material layer 40 is preferably provided between said photoconductor layer 20 and said first electrode layer 11, that is, the layer 40 is closer to the viewing side 15 than the photoconductor layer 20. The light filter and/or reflective layer 68 is preferably provided between layers 20 and 40. Preferably, a visible light reflecting and/or scattering material is preferably provided between an electrochromic material and the photoconductor layer, so as to prevent visible light entering from the viewing side 15 to reach the photoconductor layer 20.

The display of the claimed invention comprises first, second and third different electrochromic materials 41, 42, 43. The first, second and third different electrochromic materials preferably have different, first second and third colors when being activated. The terms "activated", "activation", and its various grammatical forms, in the context of the electrochromic material, is intended to refer to the colored state of the electrochromic material. The color status of said first, second and third different electrochromic materials preferably depends on a voltage potential and/or current flow between said first and second electrode layers 11, 12. As mentioned elsewhere, the electrodes 11, 12 are provided to have locally limited and/or defined current flow and/or voltages, due to locally changed conductivity in the photodiode 20.

The different electrochromic materials are preferably provided to provide a multi-color and/or full-color display. The different electrochromic materials are provided in first, second and third spatially separate regions 44, 45, 46.

The display 110 shown in **Figure 1B****,** comprises first, second and third spatially separated regions 44-46, which here are juxtaposed and/or provided as substantially coplanar regions or areas of the electrochromic material layer 40. In a preferred embodiment, the first, second and third regions are separated and/or spaced apart on the horizontal axis and/or on an axis that is parallel to the viewing side 15 or of the first substrate 91 of the display. Preferably, the first, second and third regions 44-46 are aligned vertically (i.e. they are provided at the same vertical position), on an axis that extends normal to the viewing side 15. Accordingly, as shown, the first, second and third regions extend in parallel to the viewing side 15.

The spatially separated regions 44-46 preferably form pixels or sub-pixels of the display. They are also referred to as first, second and third electrochromic regions 44-46.

In an embodiment, said spatially separated regions 44-46 each cover independently a surface of about 10 µm² to about 100 mm², preferably about 50 µm² to about 50 mm², most preferably about 100 µm² to about 20 mm².

In an embodiment, said first, second and third different electrochromic materials 41, 42, 43 comprise electrochromic materials that have a red, green and blue, respectively, colored in their colored state, provided to allow for RGB or other forms of additive color mixing. The invention also encompasses other types of color mixing, such as CMY and CMYK (cyan, magenta, yellow, black) and other forms of substrative color mixing.

While the display illustrated in Fig. 1B and other figures comprise three different electrochromic materials, the invention may be realized with four or more different electrochromic materials, wherein the display may or may not comprise four or more spatially separated regions.

The figures show clear separations between neighbouring and/or adjacent regions 41-43.

In a preferred embodiment, the display of the invention comprises one or more infrared (IR) filtering material. The IR filtering material may be provided within the electrochromic material layer 40, in the filtering and/or reflective layer 68, or may be provided in a separate layer, as described in more detail elsewhere in this specification. In a preferred embodiment, an IR material is a compound, preferably a small or medium sized molecule.

In a preferred embodiment, the IR filtering material selectively filters some IR radiation and/or is selectively transmissive to some IR radiation.

In an embodiment, the IR filtering material absorbs and/or reflects at least some IR light. Preferably, the IR filtering material filters, absorbs and/or reflects IR light characterized by a particular wavelength or wavelength range.

In a preferred embodiment, the display comprises first, second and third different IR filtering materials and/or first, second and third pluralities of IR filtering materials. Preferably, these different IR filtering materials are transmissive to different wavelengths and/or wavelength ranges of IR light.

For the purpose of the present specification, a "plurality of IR filtering materials" encompasses the situation where two or more different IR filtering materials are combined to obtain a desired IR filtering effect. A "plurality of IR filtering materials" encompasses a "combination", a "group" and/or a "composition" comprising two, three or more different IR filtering materials. There may be up to 10, preferably up to 5, most preferably up to 3 different IR filtering materials in a plurality of IR filtering materials. In particular, IR filtering materials in a "plurality of IR filtering materials" are selected so as to block, for example absorb, some IR light but to let pass a particular wavelength and/or wavelength range of IR light intended for activating the electrode associated with the corresponding region and/or area.

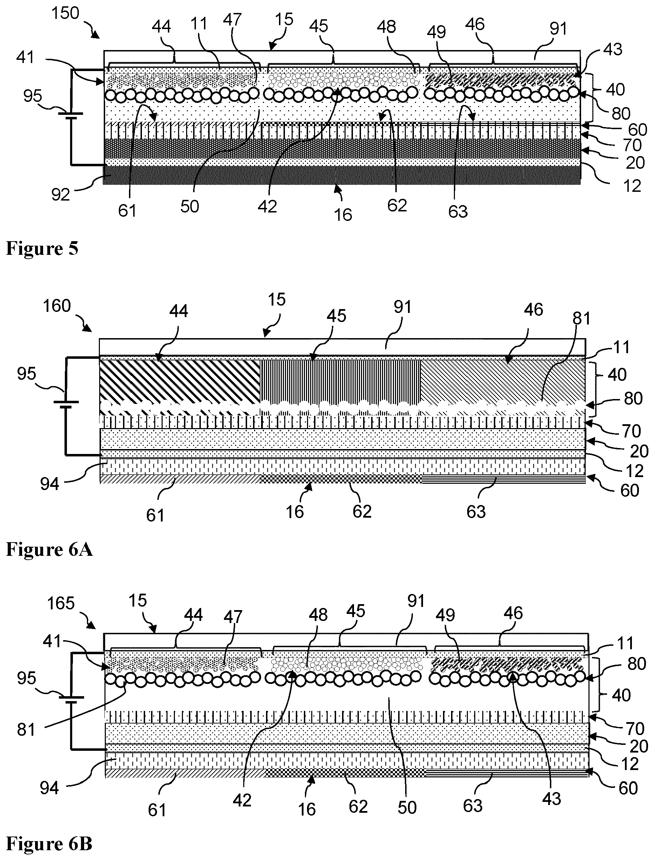

The first, second and third different IR filtering materials and/or pluralities of IR filtering materials, as applicable, are preferably provided in spatially separate regions, respectively. For example, with respect to the display 110 shown in Fig. 1B, the first, second and third different IR filtering materials and/or different pluralities of IR filtering materials may be provided, respectively, in said first, second and third separated regions 41-43, or in a separate layer 60 as will be described in more detail with respect to the embodiments shown in Figs 4 and 5.

In an embodiment, said first, second and third different IR filtering materials and/or different pluralities of IR filtering materials are provided in different regions that are co-planar with respect to each other, as will be described with respect to the embodiments shown in Figs 4 and 5.

Said first, second and third different IR filtering materials and/or pluralities of IR filtering materials are preferably deposited so as to cover and/or be confined to having defined areas, regions and/or positions within the device. In a first region, a first IR material or a first plurality of different IR filtering materials may be provided. In a second region, a second IR material or a second plurality of different IR filtering materials may be provided. In a third region, a third IR material or a third plurality of different IR filtering materials may be provided. Accordingly, while for some regions a single IR material may be sufficient, other regions may comprise independently one, two or more different IR filtering materials. The different regions comprise different IR filtering materials and/or different combinations of IR filtering materials.

With the components of the embodiments shown in Figs 1A and 1B having been set forth, the operation principle of the display of the invention will now be described with reference to Figures 2A and 2B at the example of a full-color display of Fig. 1B.

In **Figure** 2A, the arrows 1 represent the environmental electromagnetic radiation impinging from the front side 15 to the display 120. The front substrate 91 and the first electrode 11 are transparent, letting the light to enter the display and reach the filtering and/or reflective layer 68. At this stage, the electrochromic material is considered not to be activated, such that all visible light proceeds unhindered to the filtering and/or reflective layer 68.

All or nearly all light of the visible spectrum is preferably reflected at the filtering and/or reflective layer 68, as illustrated by arrows 2. However, since layer 68 is transmissive at least some light of the IR spectrum, IR light having certain wavelengths passes the layer 68 and enters the photoconductor layer 20, depending on the property of layer 68. It is noted that the IR content in environmental radiation does generally not have an intensity that is sufficient to activate the photodiode 20, or, put the other way round, the photodiode is designed not to be sensitive to environmental IR radiation.

Arrows 3.1, 3.2 and 3.3 illustrate IR light emitted by a source of addressing light for driving the display 120, for example a projector as recited previously. In the embodiment shown, the light source is capable of emitting selectively wavelengths or wavelength ranges of IR light.

In the embodiment shown, a first addressing light 3.1 has a wavelength in the range of from 700 to 750 nm, a second addressing light 3.2 has a wavelength in the range of from 750 to 800 nm, and a third addressing light 3.3 has a wavelength in the range of from 800 to 850 nm. In this embodiment, said first, second and third IR filtering materials 61-63 are permissive to IR light of about 700 to about 750nm, about 750 to about 800nm, and about 800 to about 900nm, respectively. In general, first, second and third IR filtering materials are permissive to different wavelengths or different wavelengths ranges of IR light, and an overlap is preferably avoided. For example, IR light having a wavelength of 750 nm only passes one filtering material, but is filtered, absorbed and/or reflected by the other two or more IR filtering materials. The complementary filtering properties apply to the other filtering materials in an analogous manner in accordance with this example, i.e., IR light having a wavelength of, e.g., 800nm only passes one filtering material but is filtered, absorbed and/or reflected by the two other two or more IR filtering materials. And the same again, for another IR wavelength, for the third and possibly for a fourth IR wavelengths of addressing light.

The addressing IR light penetrates through the electrochromic layer 40 and further selectively through the filtering and/or reflective layer 68. The display comprises first, second and third IR light filtering materials, which are locally separated and/or associated with the first, second and third regions 44-46 comprising the first, second and third electrochromic materials.

For the purpose of the present specification, the expression "associated with", when used in the context with one or more particular regions, is intended to mean that the corresponding material, compound, or plurality of materials are spatially distributed and/or confined so as to be inside the particular region or be aligned with that region so as to overlap or substantially be superimposed with the respective region when seen in a direction that is normal to the viewing surface 15 of the display.

As indicated by the numbers in the photoconductive layer 20 in Fig. 2A, a first IR filtering material is transmissive to IR light with a wavelength situated in the range of 700-750 nm. The first IR filtering material may be provided in the first electrochromic region 44, in a separate compartment of layer 68, or in a separate layer. However, said first IR filtering material overlaps mainly and/or coincides spatially substantially with the first electrochromic region. Preferably, this applies to the direction that is normal to the viewing surface 15, which corresponds to the main direction by which addressing light 3.1, 3.2 and 3.3 enters the display.

Similarly, second and third IR filtering materials are transmissive to IR light with a wavelength situated in the range of 750-800 nm and 800-850 nm, respectively, wherein said second and third IR filtering materials are provided so as to spatially substantially coincide with said second and third electrochromic regions, respectively, in the direction that is normal to the viewing surface 15.

As illustrated by the arrow with reference numeral 4, the addressing light 3.1 is generated to be sufficient to activate the photodiode 20 in a locally defined manner at the first electrochromic region 44. The free charge carriers generated by the photodiode will trigger a current flow 4 through the first and second electrodes 11, 12, which flow will be concentrated at the region 44 of the first electrochromic material. The anisotropic conducting layer 70 is provided to suppress cross-talk by restricting current flow locally.

The current flow 4 through the electrochromic layer 40 will induce a color change in the electrochromic material contained in the layer, as is typical for electrochromic materials. If current flow is induced in the first electrochromic region 44, as illustrated in Fig. 2A by arrow 4, the first electrochromic material in the first electrochromic region 44 will change the color status from transparent to colored. Environmental light 1 entering the display from the front side 15 will be reflect the color of the first electrochromic material, which here is exemplified as being red. In the result, a red color, or more generally, a color having a red-color component, will be visible to the user viewing the display at the area, pixel and/or subpixel that has been irradiated with addressing light 3.1.

**Figure 2B** illustrates how full-color, passive (reflective) images addressed by IR light impinging from the front-side can be generated. The first, second and third electrochromic regions 44-46 together generate a particular color by color mixing as a result of the intensity of the corresponding addressing IR wavelength ranges entering the display from the front and/or viewing side 15.

The electrochromic regions 44-46 can be considered as sub-pixels producing together a particular color by RGB color mixing, such that the three regions as shown in Fig. 2B form one pixel having one color, wherein the color depends on the percentage of light of each of the addressing wavelengths or wavelength ranges emitted by the light source and directed towards a particular area or pixel. The percentages x%, y% and z% reflect the amount or intensity of the different wavelengths contributing to the generation of the color of the pixel. For example, if all three wavelength ranges impinging on the pixel have the same intensity, current flow will be induced in all regions 44-46 and all red, green and blue electrochromic materials will pass to the colored state, displaying altogether a dark pixel produced by RGB color mixing in this case. If, for example, no IR light in the range of 750-900 nm is emitted by the light source (y and z being zero), and only IR light activating the photoconductor associated with the first electrochromic region 44, only the first electrochromic material in the first region or sub-pixel 44 will change from transparent to colored, such that the overall pixel will reflect red light. Due to the layer 68, reflecting white light, the pixel color will be visible by the contrast of the pixel color with respect to a white or at least clear or bright background 68. As can be understood, the pixel can be activated by the addressing light 3 to have any color obtainable by RGB color mixing in this example, by controlling the particular IR wavelengths or wavelength ranges projected to the viewing side of the display. Furthermore, the source of addressing light is provided to emit patterned light and/or to project light so as to impinge on the entire display and its pixels. Accordingly, an image can be produced on the display by way of composition and patterning of the light projected to the display. It is noted that the projected light is preferably invisible IR light, which does not interfere with the light as reflected by the electrochromic materials in the device and thus with the image display.

For removing an image displayed by the pixels as described, bleaching of the electrochromic material is conducted, which is preferably controlled via the voltage applying unit 95. For example, the voltage source may simply short circuited between 11 and 12, or apply an inverse potential may be applied, such that the electrochromic materials will undergo a redox reaction and change to the transparent state over the entire display surface.

The display of the invention may be realized in many different ways and the present invention is not intended to be limited with respect to any particular way to work the claimed subject matter. Figures 3 through 6A concern different particular embodiments, including embodiments where the addressing light is provided from the back side (Figs 6A and 6B) and embodiments where the display is at least partially transparent (Figs 7A and 7B).

For device fabrication, layers and/or components are preferably deposited from the bottom to the top of the devices as shown in the figures, with the back substrate 92 comprising the second electrode 12 being provided first, for example in the form of a conductive substrate, and additional components being deposited on the of the conductive substrate in subsequent steps. At the end, the transparent first substrate 91 comprising the transparent first electrode 11 is placed on top of the electrochromic layer 40, preferably in the form of a conductive transparent substrate. Alternatively, an electrolyte comprising several or all constituents of the electrochromic layer is added after deposition of the transparent conductive substrate 11, 91 by infiltration through an opening, preferably in the transparent conductive substrate.

In the description of embodiments below, the different layers and components of the display are discussed in an order that does not necessarily correspond to the order of applying the corresponding layer during the fabrication of the display.

The display 130 of the embodiment shown in **Figure** 3 comprises an electrochromic layer 40 deposited as a separated all-in-on layer. In this layer, the electrochromic materials are not deposited but are preferably selected from small and medium sized molecules that are able to diffuse at least to some extent within the all-in-one (AIO) matrix.

Exemplary blue, green and red, electrochromic materials that may be deposited as components of AIO compositions are given herein after. Exemplary compound 1 is 1-ethyl-1'-(2-phosphonoethyl)-[4,4'-bipyridine]-1,1'-diium cation, which has 1,1'-diethyl-[4,4'-bipyridine]-1,1'-diium is a chromic portion. Compound 1 turns blue upon activation. Exemplary compound 2 is 1-phenyl-1'-(4-(2-phosphonoethyl)phenyl)-[4,4'-bipyridine]-1,1'-diium cation. The chromic portion of compound 2 comprises 1,1'-diphenyl-[4,4'-bipyridine]-1,1'-diium. Compound 2 turns green upon activation. Exemplary compound 3 is 1-ethyl-4-(4-(1-(2-phosphonoethyl)pyridin-1-ium-4-yl)phenyl)pyridin-1-ium cation and comprises 4,4'-(1,4-phenylene)bis(1-ethylpyridin-1-ium) as a chromic core. Compound 3 turns red upon activation. In solution, these compounds may be added in the form of suitable salts, for example with a halide anion. These compounds, when not activated, are preferably substantially transparent.

AIO compositions forming the electrochromic regions 44-46 preferably comprise a solvent, one or more salts, at least one electrochromic material, preferably one or more additional redox active species, which may or may not be electrochromic. Suitable solvents may be selected from solvents including propylene carbonate, γ-butyrolactone, acetonitrile, for example. Preferably, the AOI composition further comprises a thickening agent such as a polymer, or monomers and an initiator, for thickening the composition after deposition.

Preferably, the AIO composition comprises and/or forms a liquid, gel, or semi-solid electrolyte. General contents and information about AIO based electrochromic devices are mentioned in Alesanco et al, "All-in-One Gel-Based Electrochromic Devices: Strengths and Recent Developments", Materials, 2018, 11, 414.

In the embodiment shown Fig. 3, the different regions 44-46 are co-planar and/or juxtaposed. In an embodiment, the different regions comprising different electrochromic materials are provided one next to each other and/or are arranged side by side, preferably co-planarly, substantially co-planarly. In the embodiments shown, the different electrochromic regions are vertically aligned. The different electrochromic regions may be deposited as different AIO compositions by printing techniques, for example by ink-jet printing or other depositing instrument device suitable to deposit different compositions at different positions on a surface. The different electrochromic materials contained in the different regions may thereby be contained in different compositions (different inks), each deposited so that the different compositions form the different regions. Alternatively, a single initial composition may be pre-deposited over an area covering several subpixels, for example over the entire area covered by the display, and the different regions are formed in a separate step, in which the different electrochromic materials are deposited to the pre-deposited composition at the different regions. Such separate deposition of particular components to a pre-deposited overall composition may be done with a suitable aligning device, capable of depositing particular components at pre-defined localities of the pre-deposited composition. Physical separations between regions may be produced by selective curing, which may be conducted before or after the separate deposition of the different electrochromic materials.

In an embodiment, the adjacent and/or side-by-side disposition of the different regions 44-46 may involve a partial overlap of adjacent regions. In some embodiments, there is no overlap, but a region may still be in contact with one or more of the adjacent, neighboring regions. In yet another embodiment, the regions are laterally spaced apart, for example separated by a gap and/or by a separating wall.

In a preferred embodiment, said one or more IR filtering material 61 is provided in said electrochromic material layer 40.

In the embodiment shown in Fig. 3, different IR filtering and/or absorbing materials are provided inside the different regions, in particular in the different AIO compositions of the different regions. In particular, a first IR filtering material 61 is contained in a first electrochromic region 44, a second IR filtering material 62 is contained in a second electrochromic region 45, and a third IR filtering material is contained in a third electrochromic region 46. In this embodiment, the IR filtering materials are contained as molecules or particles in the AIO compositions forming the electrochromic regions, preferably in the form of small or medium sized molecules.

Exemplary compounds of IR filtering materials having different IR filtering characteristics are selected from the compounds provided below.

Aluminum 1,8,15,22-tetrakis(phenylthio)-29H,3 1H-phthalocyanine chloride (CAS No. 167093-23-4) absorbs IR light in the range of 752-759 nm (compound 4). Vanadyl 2,11,20,29-tetra-tert-butyl-2,3-naphthalocyanine (CAS No 105011-00-5) filters IR light at 805-811 nm (compound 5). Copper (II) 5,9,14,18,23,27,32,36-octabutoxy-2,3-naphthalo-cyanine (CAS No. 155773-67-4) filters light at 850-856 nm (compound 6).

Referring to the exemplary embodiment shown in Fig. 2A, region 44, activated with IR light of 750nm, may be associated with a combination of compounds 5 and 6. Region 45, activated with IR light of about 805 nm, may be associated with a combination of compounds 4 and 6. Region 46, activated with IR light of about 850 nm, may be associated with a combination of compounds 4 and 5.

The IR filtering and/or absorbing materials may be added to the corresponding AIO composition as described with respect to the different electrochromic materials, either as part of different compositions that are deposited at different, juxtaposed positions, or as compounds that are added in a separate step after deposition of an overall initial composition, as described above with respect to the different electrochromic materials. In an embodiment, the first IR reflecting material 61 and the first electrochromic material 41 are contained in a solution that is deposited to a pre-deposited initial composition in a separate step. The same applies to the second and third IR reflecting and electrochromic materials, 42, 62 and 43, 63, respectively.

The embodiment shown in Fig. 3 further comprises a white light scattering material or layer 80, which is deposited as a separate layer, preferably on top of the anisotropic conductive layer 70, or, if the latter is absent, on top of the photoconductor layer 20. Preferably, the light scattering material or layer 80 is deposited by screen printing in form of a paste comprising white light scattering nanoparticles, followed by the evaporation of solvent used for depositing the particles. Exemplary particles are disclosed elsewhere in this specification.

The first electrode 11 is preferably transparent and may be preferably comprise or consist essentially of a transparent conductive material, for example selected from transparent conductive oxides and transparent conductive polymers. For example, conductive electrode materials may be selected from SnO₂, fluorine doped tin oxide (FTO), indium doped tin oxide (ITO), aluminium zinc oxide, and PEDOT. The first substrate 91 and the first electrode 11 may be provided in the form of a transparent conductive substrate, such as transparent glass or plastic on which one of the above-mentioned conductive materials has been deposited.

The second electrode 12 and second substrate 92 of the embodiment shown in Fig. 3 may be provided as with the first electrode and substrate, with the difference that they do not need to be transparent. Accordingly, the second electrode 12 may also be formed by a metal film, for example.

The photoconductor layer 20 and the anisotropic conductive layer 70 have already been described with reference to Figures 1A and 1B above.

The particularities of the device as shown in Fig. 3 are that the electrochromic layer 40 is provided in to form of different AIO compositions comprising different non-deposited, and/or diffusing electrochromic materials and that different IR filtering materials are contained in the AIO compositions of the different regions of the electrochromic layer. Furthermore, the white light scattering layer 80 is deposited to be adjacent to the anisotropic layer 70, for example towards the lower or bottom part of the electrochromic material layer, where "lower" and "bottom" mean the side of layer 40 that is closer to the second substrate 12 and/or the back side 16 of the display.

It is noted that the IR filtering materials 61-63 and the white light scattering and/or reflecting layer 80 in Fig. 3 correspond to what is indicated to be the light reflecting material and/or filtering layer 68 in Figs. 1A-2B. In this case, all materials may be integrated inside the electrochromic layer 40 instead of being provided as vertically separated layers.

**Figure** 4 shows a display 140 that differs from the embodiment shown in Fig. 3 in that the different IR filtering materials 61-63 (or pluralities of filtering materials) are deposited as a separate IR filtering layer 60 and are thus preferably no longer contained as diffusing or dispersed components in the electrochromic layer 40.

The different IR filtering materials, such as the first, second and third different IR filtering materials 61-63 are deposited in a spatially separated manner. Preferably, they are aligned with and/or substantially overlap with first, second and third regions 44-46 of the electrochromic material layer 40. Accordingly, in the separate IR filtering layer 60, the first IR filtering material 61 is provided vertically below the first region 44, the second IR filtering material 62 is provided vertically below the second region 45, and the third IR filtering material 63 is provided vertically below the first region 46. Furthermore, the surfaces covered by the different IR filtering materials in layer 60 are preferably substantially similar or identical to the corresponding surfaces of the different regions of the electrochromic layer 40. Accordingly, the respective IR wavelength and/or wavelength range that can pass through a corresponding (e.g. first, second or third) IR filtering material will effectively activate the photoconductor layer 20 only in the area defined by the corresponding IR filtering material and thus activate the respective (first, second or third) electrochromic material situated vertically above the corresponding IR filtering material.

In the embodiment shown in Fig. 4, the IR filtering layer 60 is conductive as is anisotropic conductive layer. Commercially available anisotropic layers are generally provided with an insulating layer, which can however be rendered conductive by extending conductive lines contained in the anisotropic layer. The different IR filtering materials can be provided in the insulating layer and rendered conductive by the conductive lines, as shown by the plurality of vertical conductive lines crossing layers 60 and 70 in each region of defined by the different IR filtering materials in Fig. 4.

**Figure** 5 shows a display 150 wherein the electrochromic layer 40 is of a layered type according to the distinction made in Alesanco et al, 2018, cited above. In such layered devices, one or more electrochromic materials are deposited and/or are provided in the form of a layer, in contrast to diffusing materials. Electrochromic materials in layered devices encompass polymers and deposited particles.

Layered electrochromic device architectures have generally faster switching times. Displays 150, 165 and 175 (Figs 5, 6B and 7B) may be preferred for displays where a comparatively fast switching time is important.

In an embodiment, said electrochromic material layer 40 comprises a mesoporous layer and/or nanoparticles 47-49. Preferably, one or more electrochromic material 41-43 is deposited on said mesoporous layer and/or on said nanoparticles. In another embodiment, one or more electrochromic material 41-43 is provided as such in a mesoporous form and/or in the form of nanoparticles.

In an embodiment, said electrochromic material layer 40 comprises an electrolyte 50.

In the embodiment shown in Fig. 5, different regions 44-46 in the electrochromic layer 40 are defined by different electrochromic materials 41-43 deposited in a spaced-apart, spatially separate manner in the form of different particles 47-49 or, preferably, different (e.g. first, second and third) electrochromic materials 41-43 deposited or anchored on a mesoporous layer, preferably formed from nanoparticles 47-49, for example a mesoporous TiO₂ layer. The different electrochromic materials 41-43 and/or the mesoporous layer may be deposited onto the first electrode 11, preferably on a transparent conductive substrate comprising the first electrode 11, as is conventional, including, if appropriate, a sintering step for annealing the nanoparticles on the transparent electrode.

In an embodiment, said nanoparticles 47-49 are immobilized within said electrochromic material layer 40, for example deposited in a permanent manner to another layer and/or to an electrode layer. Preferably, the nanoparticles are not provided in a manner allowing them to migrate within the electrochromic material layer 40, e.g., during the operation of the display. For example, the deposition of nanoparticles on the first electrode followed by annealing would result in a permanent, non-mobile arrangement of the nanoparticles within the display.

In an embodiment, the white light scattering and/or reflecting material 80 is provided in said electrochromic material layer 40, preferably between said mesoporous layer and/or nanoparticles 47-49 and said photoconductor layer 20 or, if present, said anisotropic material layer 70, more preferably in said electrolyte 50.

The white light scattering and/or reflecting layer 80 is preferably provided in the form of particles deposited on the different electrochromic materials 41-43. The particles for layer 80 are preferably selected from nano- or microparticles having a diameter of 100 nm to 5 µm, preferably 150-2000 nm, more preferably 200-1000 nm. They may be selected from TiO₂, SiO₂, Al₂O₃ or other and/or related, particulate metal oxide materials, preferably in the form of white nanoparticles, for example.

The electrolyte 50 is provided in the electrochromic layer 40, the electrolyte preferably comprising one or more salts and optionally redox active species, for rendering the electrochromic device functional. A ion storage layer, although not specifically shown in Fig. 5, may also be provided in the electrochromic layer, preferably at the side of layer 40 that is oriented towards the back-side 16 of the device, for example in vicinity of the IR filtering layer 60.

The IR filtering layer 60 and the anisotropic layer 70 of the display 150 are preferably as described with respect to the display 140 shown in Fig. 4.

**Figures 6A** and **6B** show back-driven displays 160 and 165, respectively. In these displays, the back substrate 94 on the back-side 16 is preferably transmissive to IR light and non-transparent to visible light, or partially transparent (semi-transparent) to visible light.

In an embodiment, the display comprises a back substrate 94, which is transparent to IR light and optionally non-transparent to visible light, wherein said second electrode 12 is supported by and/or deposited on said back substrate 94, wherein said one or more IR filtering material 61 is deposited on said back substrate 94, is provided in a separate layer on said back substrate 94, and/or is provided between said second electrode layer 12 and said back substrate 94.

In an embodiment, the display comprises a white light and/or all light scattering and/or reflecting material 81. The white/all light scattering layer may be provided, for example, between said electrochromic material layer 40 and said photoconductor layer 20, or in said electrochromic material layer 40. Preferably, the white light and/or all light scattering and/or reflecting material 81 is provided between said one or more electrochromic material 41-43 and said photoconductor layer 20. The scattering layer may also be provided elsewhere anywhere between said first and second electrode layers or even outside said first and/or second electrode layers.

In the embodiments shown in Figs. 6A and 6B, the IR reflecting layer 60 comprising preferably different IR reflecting materials is deposited on the back substrate 94. In the case of a (full-) color device, different IR reflecting materials are spatially separated in the IR reflecting layer 60 as described with respect to Figs 4 and 5, for example.

In Fig. 6A, the electrochromic layer 40 is of the AIO type as described with respect to Figs 3 and 4, whereas in Fig. 6B the electrochromic layer is of the layered type as described with respect to Fig. 5. Accordingly, the white light scattering and/or reflecting layer 80 is deposited towards in the bottom part of the electrochromic layer in Fig. 6A and, respectively on the mesoporous layer comprising the electrochromic materials 41-43 in Fig. 6B.

The displays 160 and 165 are preferably back driven. In other words, the addressing IR light enters the device and in particular the photoconductor layer 20 via the back side 16 of the display. In this embodiment, the display side 15, here considered to be the front side, is opposed to the photo-addressing side, which here is the backside 16.

Back-driven displays 160 and 165 as shown in Figs 6A and 6B, respectively, may be useful for outdoor use, for example, where a projector can be placed behind the display. Alternatively, displays 160 and 165 encompass displays in which the addressing light source is integrated in the device, for example directly and/or rigidly attached to the display at or towards the back side 16.

**Figures** 7A and **7B** show displays 170 and 175 that are transparent to at least some visible light and may thus be considered as transparent or semi-transparent. Such displays may be used where transparency is desired, for example integrated in a building, as a partially transparent wall and/or as a window.

The displays 170 and 175 differ from the displays 140 and 150 shown in Figs 4 and 5, respectively, in that the back substrate 93 is transparent to visible light, too, besides being transparent to IR light. Furthermore, the photoconductor layer 20 is preferably transparent to visible light, while still being drivable by IR light as described elsewhere. As the displays 170 and 175 are sought to be as transparent as possible, a white light scattering layer 80 is preferably absent.

The displays 170 and 175 are preferably front-driven, such that the addressing IR light preferably enters the light from the front side 16, as described with respect to Figs 2A and 2B. Displays 170 and 175 differ from each other with respect to the electrochromic layer 40, which in Fig. 7A is of the AIO type and in Fig. 7B of the layered type, as described herein above with respect to Figs 4 and 5, respectively.

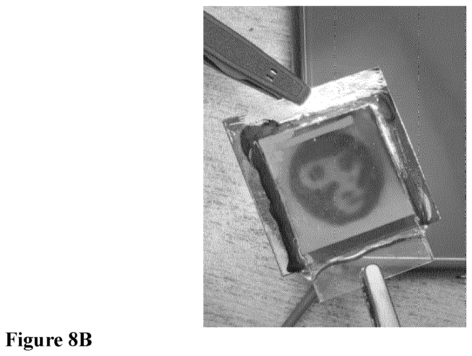

**Figure 8A** shows the architecture of a single-color display 180 , which is not according to the claims, that was fabricated in accordance with an example. **Figure 8B** shows the photograph of this exemplary device.

For preparing the device, with reference to Fig. 8A, two fluorine-doped tin oxide (FTO) electrodes 111 and 112 are deposited on glass substrates 191 and 192, respectively. A photoconductive diode 120 is formed by a compact titanium dioxide (TiO₂) layer, a mesoporous TiO₂ layer, an organic-inorganic halide perovskite layer, and a hole-transporting layer, deposited in this order on the bottom FTO electrode 112.

The EC layer 140 is comprised of a viologen-loaded mesoporous TiO₂ layer 141, deposited on the electrode 111, and a liquid electrolyte 150. A reflective material comprised of Al₂O₃ nanoparticles 180 is deposited on the viologen-loaded mesoporous TiO₂ layer 141. An anisotropic conducting interlayer 170 was applied between the photoconductive diode 120 and the EC layer. The device is driven with a suitable light source.

While certain of the preferred embodiments of the present invention have been described and specifically exemplified above, it is not intended that the invention be limited to such embodiments. Various modifications may be made thereto within the scope of the present invention, as defined by the following claims.

## Claims

1. A photo-addressed and/or photo-addressable display (110) comprising:
- first and second electrode layers (11, 12);
- a photoconductor layer (20), provided between said electrode layers, said photoconductor layer comprising a material that is sensitive to infrared (IR) light;
- an electrochromic material layer (40), provided between said photoconductor layer (20) and said first electrode layer (11), wherein said electrochromic material layer comprises first, second and third different electrochromic materials (41-43), provided in first, second and third spatially separate regions (44-46) in said electrochromic material layer (40).

2. The display of claim 1, comprising one or more infrared (IR) filtering material (61), which is provided in said electrochromic material layer (40), in a filtering and/or reflective layer (68) or in a separate layer (60).

3. The display of any one of claims 1-2, wherein said first, second and third different electrochromic materials can change to red (41), green (42) and blue (43), respectively, upon applying an electrical current and/or voltage, respectively, provided for allowing RGB color mixing in dependence of a current and/or voltage occurring between said first and second electrode layers (11, 12).

4. The display of claim 2, wherein said one or more infrared (IR) filtering material (61) is a first IR filtering material or a first plurality of IR filtering materials, and wherein said display further comprises a second IR filtering material or a second plurality of IR filtering materials (62) and a third IR filtering material or a third plurality of IR filtering materials (63), wherein said first, second and/or third filtering material and/or plurality of IR filtering materials, as the case may be, differ with respect to at least one IR filtering material present in the respective IR filtering material or plurality of IR filtering materials.

5. The display of claim 4, wherein said first, second and third IR filtering materials and/or pluralities of IR filtering materials (61-63) are provided:
in said first, second and third spatially separate regions (44-46) comprising first, second and third different electrochromic materials (41-43), respectively, or
in a separate IR filter layer (60), said IR filter layer comprising said first, second and third IR filtering materials and/or pluralities of IR filtering materials (61-63) in spatially separate regions.

6. The display of any one of claims 4 or 5, wherein said first, second and third IR filtering materials and/or pluralities of IR filtering materials (61-63) are aligned with and/or substantially overlap with said first, second and third regions (44-46) of said electrochromic material layer (40).

7. The display of any one of the preceding claims, comprising a white light scattering and/or reflecting material (80), provided in said electrochromic material layer (40), in a layer (60) comprising said one or more infrared (IR) filtering material (61), or in a separate layer, wherein said white light scattering and/or reflecting material (80) preferably provides a background for information and/or images displayed on said display,
and wherein said white light scattering and/or reflecting material (80) is preferably permissive to IR light.

8. The display of any one of the preceding claims, wherein said photoconductor layer (20) comprises one or more selected from an organic-inorganic perovskite photodiode, a silicon photodiode and an NIR sensitive photodiode comprising another photoactive material.

9. The display of any one of the preceding claims, further comprising a bias voltage applying unit (95) for providing a bias voltage between said first and second electrodes (11, 12).

10. The display of any one of the preceding claims, further comprising a back substrate (92, 93), wherein said second electrode (12) is supported by and/or deposited on said back substrate, and wherein said back substrate (92, 93) is a transparent back substrate (93) or is a back substrate (92) that is non-transparent to visible light.

11. The display of any one of the preceding claims, further comprising a light irradiation unit configured for emitting IR light, and preferably IR light of three or more different wavelengths or wavelengths ranges, and preferably wherein said light irradiation unit is a source of patterned IR light.

12. The display of any one of the preceding claims, wherein said electrochromic material layer (40) comprises a mesoporous layer and/or nanoparticles (47-49) on which one or more electrochromic material (41-43) is deposited, and wherein said electrochromic material layer (40) comprises an electrolyte (50).

13. The display of any one of claims 8-12, when dependent on claim 7, wherein said white light scattering and/or reflecting material (80) is provided in said electrochromic material layer (40).

14. The display of any one of claims 1-11, wherein said first, second and third different electrochromic materials (41-43) are provided free to diffuse and/or non-bound within said electrochromic material layer (40), and are preferably provided in the form of a non-deposited and/or non-polymeric material, material which is preferably selected from small and medium sized molecules.

15. The display of any one of claims 1-7, comprising a transparent back substrate (93), wherein said second electrode (12) is supported by and/or deposited on said transparent back substrate (92), wherein a white light scattering and/or reflecting material (80) for reflecting white light and providing a white background is absent, and wherein said photoconductor layer (20) is preferably transparent to at least part of visible light.

16. The display of claim 1, further comprising a visible light reflecting material and/or layer (68, 80), reflecting all and/or nearly all light of the visible spectrum and providing a preferably clear and/or bright background against which information and/or images are displayed on said display, wherein said visible light reflecting material and/or layer is transmissive to at least some wavelengths of IR light.

## Patentansprüche

1. Eine lichtgesteuerte und/oder lichtsteuerbare Anzeige (110), umfassend:
- eine erste und eine zweite Elektrodenschicht (11, 12);
- eine Fotoleiterschicht (20), die zwischen den genannten Elektrodenschichten angeordnet ist, wobei die Fotoleiterschicht ein Material umfasst, das gegenüber Infrarotlicht (IR) empfindlich ist;
- eine elektrochrome Materialschicht (40), die zwischen der Photoleiterschicht (20) und der ersten Elektrodenschicht (11) angeordnet ist, wobei die elektrochrome Materialschicht ein erstes, ein zweites und ein drittes unterschiedliches elektrochromes Material (41-43) umfasst, die jeweils in einem ersten, einem zweiten und einem dritten räumlich separaten Bereich (44-46) in der elektrochromen Materialschicht (40) angeordnet sind.

2. Die Anzeige nach Anspruch 1, umfassend ein oder mehrere Infrarot (IR)-Filtermaterialien (61), die in der elektrochromen Materialschicht (40), in einer Filter- und/oder Reflexionsschicht (68) oder in einer separaten Schicht (60) vorgesehen sind.

3. Die Anzeige nach einem der Ansprüche 1-2 beschriebene Anordnung, wobei das erste, zweite und dritte unterschiedliche elektrochrome Material bei Anlegen eines elektrischen Stroms bzw. einer elektrischen Spannung jeweils in Rot (41), Grün (42) und Blau (43) wechseln können, wodurch eine RGB-Farbmischung in Abhängigkeit von einem Strom und/oder einer Spannung ermöglicht wird, die zwischen der ersten und der zweiten Elektrodenschicht (11, 12) eintritt.

4. Die Anzeige nach Anspruch 2, wobei das eine oder die mehreren Infrarot (IR)-Filtermaterialien (61) ein erstes IR-Filtermaterial oder eine erste Pluralität von IR-Filtermaterialien ist, und wobei die Anzeige ferner ein zweites IR-Filtermaterial oder eine zweite Pluralität von IR-Filtermaterialien (62) sowie ein drittes IR-Filtermaterial oder eine dritte Pluralität von IR-Filtermaterialien (63) umfasst, wobei sich das erste, zweite und/oder dritte IR-Filtermaterial und/oder die erste, zweite und/oder dritte Pluralität von IR-Filtermaterialien, je nach Fall, hinsichtlich mindestens eines in dem jeweiligen IR-Filtermaterial oder der jeweiligen Pluralität von IR-Filtermaterialien vorhandenen IR-Filtermaterials unterscheiden.

5. Die Anordnung nach Anspruch 4, wobei das erste, zweite und dritte IR-Filtermaterial und/oder Pluralitäten von IR-Filtermaterialien (61-63) vorgesehen sind:
in den ersten, zweiten und dritten räumlich separaten Bereichen (44-46), die jeweils erste, zweite und dritte unterschiedliche elektrochrome Materialien (41-43) umfassen, oder
in einer separaten IR-Filterschicht (60), wobei die IR-Filterschicht das erste, zweite und dritte IR-Filtermaterial und/oder Pluralitäten von IR-Filtermaterialien (61-63) in räumlich getrennten Bereichen umfasst.

6. Die Anzeige gemäss einem der Ansprüche 4 oder 5, wobei das erste, zweite und dritte IR-Filtermaterial und/oder Pluralitäten von IR-Filtermaterialien (61-63) jeweils am ersten, zweiten und dritten Bereich (44-46) der elektrochromen Materialschicht (40) ausgerichtet sind und/oder mit diesen im Wesentlichen überlappen.

7. Die Anzeige gemäss einem der vorstehenden Ansprüche, umfassend ein weißes Licht streuendes und/oder reflektierendes Material (80), das angeordnet ist: in der elektrochromen Materialschicht (40), in einer Schicht (60), die das eine oder die mehreren Infrarot (IR)-Filtermaterialien (61) umfasst, oder in einer separaten Schicht, wobei das weisses Licht streuende und/oder reflektierende Material (80) vorzugsweise einen Hintergrund für auf der Anzeige dargestellte Informationen und/oder Bilder bildet
und wobei das weisses Licht streuende und/oder reflektierende Material (80) vorzugsweise für IR-Licht durchlässig ist.

8. Die Anzeige gemäß einem der vorstehenden Ansprüche, wobei die Photoleiterschicht (20) eine oder mehrere der folgenden Komponenten umfasst: eine organisch-anorganische Perowskit-Fotodiode, eine Silizium-Fotodiode und eine NIR-empfindliche Fotodiode, die ein anderes photoaktives Material enthält.

9. Die Anzeige gemäß einem der vorstehenden Ansprüche, die ferner eine Vorspannungs-Anlegeeinheit (95) umfasst, um eine Vorspannung zwischen der ersten und der zweiten Elektrode (11, 12) bereitzustellen.

10. Die Anzeige gemäß einem der vorstehenden Ansprüche, die ferner ein Rückseitensubstrat (92, 93) umfasst, wobei die zweite Elektrode (12) vom Rückseitensubstrat gestützt und/oder darauf aufgebracht ist, und wobei das besagte Rückseitensubstrat (92, 93) ein transparentes Rückseitensubstrat (93) oder ein für sichtbares Licht undurchlässiges Rückseitensubstrat (92) ist.

11. Die Anzeige gemäß einem der vorstehenden Ansprüche, die ferner eine Lichtbestrahlungseinheit umfasst, die zur Emission von IR-Licht ausgelegt ist, vorzugsweise von IR-Licht mit drei oder mehr verschiedenen Wellenlängen oder Wellenlängenbereichen, wobei die Lichtbestrahlungseinheit vorzugsweise eine Quelle für strukturiertes IR-Licht ist.

12. Die Anzeige gemäss einem der vorstehenden Ansprüche, wobei die besagte elektrochrome Materialschicht (40) eine mesoporöse Schicht und/oder Nanopartikel (47-49) umfasst, auf der und/oder denen ein oder mehrere elektrochrome Materialien (41-43) aufgetragen sind, und wobei die elektrochrome Materialschicht (40) einen Elektrolyten (50) umfasst.

13. Die Anzeige gemäss einem der Ansprüchen 8 bis 12, sofern sie von Anspruch 7 abhängt, wobei das weiße Licht streuende und/oder reflektierende Material (80) in der elektrochromen Materialschicht (40) vorgesehen ist.

14. Die Anzeige gemäss einem der Ansprüche 1 bis 11, wobei das erste, zweite und dritte unterschiedliche elektrochrome Material (41-43) innerhalb der elektrochromen Materialschicht (40) frei diffundierbar und/oder ungebunden vorliegen und vorzugsweise in Form eines nicht abgeschiedenen und/oder nicht-polymeren Materials vorliegen, das vorzugsweise aus kleinen und mittelgroßen Molekülen ausgewählt ist.

15. Die Anzeige gemäss einem der Ansprüche 1 bis 7, umfassend ein transparentes Rückseitensubstrat (93), wobei die zweite Elektrode (12) auf dem transparenten Rückseitensubstrat (92) aufgebracht und/oder darauf aufgebracht ist, wobei ein weißes Licht streuendes und/oder reflektierendes Material (80) zum Reflektieren von weißem Licht und zum Erzeugen eines weißen Hintergrunds fehlt, und wobei die Fotoleiterschicht (20) vorzugsweise für zumindest einen Teil des sichtbaren Lichts transparent ist.

16. Die Anzeige nach Anspruch 1, die ferner ein Material und/oder eine Schicht (68, 80) umfasst, das bzw. die das gesamte und/oder nahezu das gesamte Licht des sichtbaren Spektrums reflektiert und einen vorzugsweise klaren und/oder hellen Hintergrund bereitstellt, vor dem auf der Anzeige dargestellte Informationen und/oder Bilder gezeigt werden, wobei das Material und/oder die Schicht, das bzw. die sichtbares Licht reflektiert, für zumindest einige Wellenlängen von IR-Licht durchlässig ist.

## Revendications

1. Écran (110) commandé par la lumière et/ou pouvant être commandé par la lumière, comprenant :
- une première et une deuxième couches d'électrodes (11, 12) ;
- une couche photoconductrice (20), disposée entre lesdites couches d'électrodes, ladite couche photoconductrice comprenant un matériau sensible à la lumière infrarouge (IR) ;
- une couche de matériau électrochrome (40), disposée entre ladite couche photoconductrice (20) et ladite première couche d'électrode (11), ladite couche de matériau électrochrome comprenant des premier, deuxième et troisième matériaux électrochromes différents (41-43), disposés dans des première, deuxième et troisième régions spatialement séparées (44-46) dans ladite couche de matériau électrochrome (40).

2. L'écran selon la revendication 1, comprenant un ou plusieurs matériaux filtrant les infrarouges (IR) (61), qui sont intégrés dans ladite couche de matériau électrochrome (40), dans une couche filtrante et/ou réfléchissante (68) ou dans une couche distincte (60).

3. L'écran selon l'une quelconque des revendications 1 à 2, dans laquelle lesdits premier, deuxième et troisième matériaux électrochromes différents peuvent passer respectivement au rouge (41), au vert (42) et au bleu (43) lors de l'application d'un courant électrique et/ou d'une tension, respectivement, prévus pour permettre le mélange des couleurs RVB en fonction d'un courant et/ou d'une tension apparaissant entre lesdites première et deuxième couches d'électrodes (11, 12).

4. L'écran selon la revendication 2, dans lequel ledit ou lesdits matériaux filtrant les infrarouges (IR) (61) constituent un premier matériau filtrant les IR ou une première pluralité de matériaux filtrant les IR, et dans lequel ledit écran comprend en outre un deuxième matériau filtrant les IR ou une deuxième pluralité de matériaux filtrant les IR (62) et un troisième matériau filtrant les IR ou une troisième pluralité de matériaux filtrant les IR (63), dans lequel ledit premier, deuxième et/ou troisième matériau filtrant et/ou pluralité de matériaux filtrant les IR, selon le cas, diffèrent par rapport à au moins un matériau filtrant les IR présent dans le matériau filtrant les IR respectif ou la pluralité de matériaux filtrant les IR respective.

5. L'écran selon la revendication 4, dans lequel lesdits premier, deuxième et troisième matériaux filtrant les IR et/ou pluralités de matériaux filtrant les IR (61-63) sont disposés :
dans lesdites première, deuxième et troisième régions spatialement séparées (44-46) comprenant respectivement des premier, deuxième et troisième matériaux électrochromes différents (41-43), ou
dans une couche de filtrage IR distincte (60), ladite couche de filtrage IR comprenant lesdits premier, deuxième et troisième matériaux filtrant les IR et/ou des pluralités de matériaux filtrant les IR (61-63) dans des régions spatialement distinctes.

6. L'écran selon l'une quelconque des revendications 4 ou 5, dans laquelle lesdits premier, deuxième et troisième matériaux filtrant les IR et/ou lesdites pluralités de matériaux filtrant les IR (61 à 63) sont alignés avec et/ou recouvrent sensiblement lesdites première, deuxième et troisième, respectivement, régions (44 à 46) de ladite couche de matériau électrochrome (40).

7. L'écran selon l'une quelconque des revendications précédentes, comprenant un matériau (80) diffusant et/ou réfléchissant la lumière blanche, disposé dans ladite couche de matériau électrochrome (40), dans une couche (60) comprenant ledit ou lesdits matériaux filtrant les infrarouges (IR) (61), ou dans une couche distincte, dans lequel ledit matériau diffusant et/ou réfléchissant la lumière blanche (80) sert de préférence de fond aux informations et/ou aux images affichées sur ledit écran,
et dans lequel ledit matériau diffusant et/ou réfléchissant la lumière blanche (80) est de préférence perméable à la lumière infrarouge.

8. L'écran selon l'une quelconque des revendications précédentes, dans lequel ladite couche photoconductrice (20) comprend un ou plusieurs éléments choisis parmi une photodiode à pérovskite organo-inorganique, une photodiode au silicium et une photodiode sensible au NIR comprenant un autre matériau photoactif.

9. L'écran selon l'une quelconque des revendications précédentes, comprenant en outre une unité d'application de tension de polarisation (95) destinée à fournir une tension de polarisation entre lesdites première et deuxième électrodes (11, 12).

10. L'écran selon l'une quelconque des revendications précédentes, comprenant en outre un substrat arrière (92, 93), dans lequel ladite deuxième électrode (12) est supportée par et/ou déposée sur ledit substrat arrière, et dans lequel ledit substrat arrière (92, 93) est un substrat arrière transparent (93) ou un substrat arrière (92) non transparent à la lumière visible.

11. L'écran selon l'une quelconque des revendications précédentes, comprenant en outre une unité d'irradiation lumineuse configurée pour émettre de la lumière infrarouge, et de préférence de la lumière infrarouge de trois longueurs d'onde ou gammes de longueurs d'onde différentes ou plus, et de préférence dans lequel ladite unité d'irradiation lumineuse est une source de lumière infrarouge structurée.

12. L'écran selon l'une quelconque des revendications précédentes, dans lequel ladite couche de matériau électrochrome (40) comprend une couche mésoporeuse et/ou des nanoparticules (47-49) sur laquelle/lesquelles est déposé un ou plusieurs matériaux électrochromes (41-43), et en ce que ladite couche de matériau électrochrome (40) comprend un électrolyte (50).

13. L'écran selon l'une quelconque des revendications 8 à 12, lorsqu'elle dépend de la revendication 7, dans lequel ledit matériau (80) diffusant et/ou réfléchissant la lumière blanche est intégré dans ladite couche de matériau électrochrome (40).

14. L'écran selon l'une quelconque des revendications 1 à 11, dans laquelle lesdits premier, deuxième et troisième matériaux électrochromes différents (41-43) sont présents sous forme libre, pouvant diffuser et/ou étant non liés au sein de ladite couche de matériau électrochrome (40), et se présentent de préférence sous la forme d'un matériau non déposé et/ou non polymère, ce matériau étant de préférence choisi parmi des molécules de petite et moyenne taille.

15. Écran selon l'une quelconque des revendications 1 à 7, comprenant un substrat arrière transparent (93), ladite deuxième électrode (12) étant supportée par et/ou déposée sur ledit substrat arrière transparent (92), un matériau (80) diffusant et/ou réfléchissant la lumière blanche destiné à réfléchir la lumière blanche et à fournir un fond blanc étant absent, et ladite couche photoconductrice (20) étant de préférence transparente à au moins une partie de la lumière visible.

16. L'écran selon la revendication 1, comprenant en outre un matériau et/ou une couche (68, 80) réfléchissant la lumière visible, réfléchissant la totalité et/ou la quasi-totalité de la lumière du spectre visible et fournissant un fond de préférence clair et/ou lumineux sur lequel des informations et/ou des images sont affichées sur ledit écran, ledit matériau et/ou ladite couche réfléchissant la lumière visible étant transmissif(ve) à au moins certaines longueurs d'onde de la lumière infrarouge.
